# EUROPÄISCHE PATENTSCHRIFT

(11) **EP 0 857 797 B1**
(45) Veröffentlichungstag und Bekanntmachung des Hinweises auf die Patenterteilung: **10.05.2000**
(21) Anmeldenummer: 97121803.7
(22) Anmeldetag: 11.12.1997
(51) Int. Cl.: C23C 18/16, C23C 18/44

(54) **Verfahren zur zumindest teilweisen Goldbeschichtung eines Trägers**
Process for coating of a substrate at least partially with gold
Procédé de revêtement d'un support au moins partiellement avec de l'or

(30) Priorität: 13.12.1996 DE 19651899; 19.12.1996 DE 19652991
(43) Veröffentlichungstag der Anmeldung: 12.08.1998
(73) Patentinhaber: AMI DODUCO GmbH, 75181 Pforzheim (DE)
(72) Erfinder: Marka, Erwin, 75203 Königsbach-Stein (DE); Moog, Dirk, 75196 Remchingen (DE)
(74) Vertreter: Twelmeier, Ulrich, Dipl. Phys.

(56) Entgegenhaltungen:
- BAKOS: "Immersion Gold as a Sensitizer for Electroless Gold Plating. September 1972." IBM TECHNICAL DISCLOSURE BULLETIN, Bd. 15, Nr. 4, September 1972, NEW YORK, US, Seite 1087 XP002062531

## Beschreibung

Die Erfindung betrifft ein Verfahren zur zumindest teilweisen Goldbeschichtung eines Trägers mit einer Grundschicht, bei dem erste Kontaktflächen auf dem Träger, die eine Goldschicht aufweisen, und zweite Kontaktflächen, die frei von der beschichteten Goldschicht der ersten Kontaktflächen sind, erzeugt werden, wobei die zweiten Kontaktflächen zuerst mit einem Abdeckmittel abgedeckt werden, wobei der Träger in ein Austausch-Goldbad eingebracht wird, wodurch auf den ersten Kontaktflächen eine Vorvergoldung ausgebildet wird, und wobei nach der Entnahme des Trägers aus dem Austausch-Goldbad die die zweiten Kontaktflächen abdeckenden Abdeckmittel entfernt werden.

Ein sehr beliebtes Kontaktierungsverfahren in der Elekronik ist das sogenannte "Bonden". Hierbei werden mit Gold- oder Aluminiumdrähten elektrische Anbindungen für ein auf dem Träger implementiertes elektronisches Bauteil geschaffen, wobei üblicherweise Golddrähte in einer Stärke von ca. 30 µm oder Aluminiumdrähte in einer Stärke von ca. 30 µm (Dünndraht-Bonden) oder 300 µm (Dickdraht-Bonden) verwendet werden.

Hierzu ist es erforderlich, daß auf dem Träger bondbare Kontaktflächen angeordnet werden. Während es beim Bonden von Aluminiumdrähten möglich ist, diese direkt auf der Chemisch-Nickel-Schicht des Trägers zu befestigen, die gegebenenfalls mit einer maximal 0,1 µm dicken Goldschicht verstärkt ist, kann auf solchen Schichten nicht mit Golddraht gebondet werden, da hierzu eine ca. 0,3 µm dicke Goldschicht erforderlich ist. Diese gegenüber dem beim Aluminiumdraht-Bonden eingesetzten Schichten deutlich dickere Goldschicht kann nur nach einer Vorvergoldung der Chemisch-Nickel-Schicht, welche eine Dicke von ca. 0,03 bis 0,08 µm aufweist, hergestellt werden, wobei diese Vorvergoldung in einem Austauschelektrolyten mit einem pH-Wert unter 7,0 und bei ca. 80 °C direkt auf die Chemisch-Nickel-Schicht abgeschieden wird. Die Verstärkung dieser Vorvergoldung auf ca. 0,3 µm erfolgt dann in einem reduktiv arbeitenden Elektrolyten, wobei hierbei eine Temperatur von 80 °C und eine stark alkalische Umgebung vorgesehen wird.

Es ist aus diesen Gründen daher bis jetzt nicht möglich, bei ein und demselben Träger gleichzeitig Gold-Bonddrähte und Aluminium-Bonddrähte zu verwenden.

Es ist daher Aufgabe der Erfindung, ein Verfahren zu schaffen, welches es ermöglicht, daß auf ein und demselben Träger sowohl mit Golddrähten als auch mit Aluminiumdrähten gebondet werden kann.

Diese Aufgabe wird durch das Verfahren nach Anspruch 1 gelöst, bei dem erfindungsgemäß vorgesehen ist, daß der Träger in ein Goldbad eingebracht wird, das einen Elektrolyten aufweist, bei dem auf der Grundschicht des Trägers keine Goldabscheidung erfolgt.

Durch die erfindungsgemäßen Maßnahmen wird in vorteilhafter Art und Weise ein Verfahren geschaffen, das es in einfacher Art und Weise erlaubt, auf einen Träger Kontaktierungsflächen sowohl für Golddrähte als auch für Aluminiumdrähte vorzusehen. Diese wird im wesentlichen durch die Verwendung des erfindungsgemäßen reduktiven Goldbades erziehlt, welches die vorteilhafte Eigenschaft besitzt, daß auf der Grundschicht, insbesondere einer Chemisch-Nikkel-Schicht, keine Goldabscheidung stattfindet, so daß diese Schichten für das Bonden mit Aluminiumdraht zur Verfügung stehen.

Vorteilhafte Weiterbildungen der Erfindung sind Gegenstand der Unteransprüche.

Weitere Einzelheiten und Vorteile der Erfindung sind dem Ausführungsbeispiel zu entnehmen, das im Folgenden anhand der einzigen Figur beschrieben wird. Es zeigt:

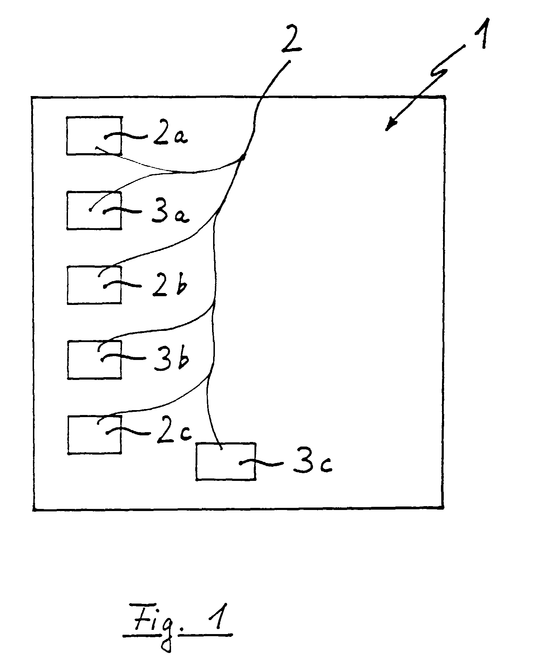

- Figur 1: eine Draufsicht auf ein Ausführungsbeispiel eines mit einer Chemisch-Nickel-Schicht überzogenen Trägers.

Der in Figur 1 dargestellte und mit 1 bezeichnete Träger weist an seiner Oberfläche eine Grundschicht, insbesondere eine Chemisch-Nickel-Schicht 2 auf, auf die Kontaktflächen 2a-2c aufzubringen sind, die zum Bonden von Golddrähten dienen und deshalb eine Goldschicht mit einer Schichtdicke von ungefähr 0,3 µm Gold aufweisen müssen. Der Träger 1 weist desweiteren Kontaktflächen 3a-3c auf, die zum Bonden von Aluminiumdrähten dienen und deshalb nicht von der die Kontaktflächen 2a - 2c ausbildenden Goldschicht überdeckt werden dürfen. Dem Fachmann ist ersichtlich, daß die beschriebene Anordnung der Kontaktflächen 2a-2c, 3a-3c auf dem Träger 1 nur zur Erläuterung des nachstehend beschriebenen Verfahrens dient und keinesfalls dessen Anwendbarkeit auf andere Kontaktanordnungen ausschließen soll.

Um nun zu gewährleisten, daß die für das Aluminiumdraht-Bonden bestimmten Kontaktflächen 3a-3c nicht in den darauffolgenden Schritten des beschriebenen Verfahrens von der in dessen Verfahrensschritten herzustellenden, die Kontaktflächen 2a-2c ausbildenden Goldschicht bedeckt werden, werden diese für das Aluminiumdraht-Bonden bestimmten Kontaktflächen 3a-3c mit Klebeband oder Lack oder einem ähnlichen Abdeckmittel abgedeckt. Zum Abdecken der Kontaktflächen 3a-3c kann eine Vielzahl von an für sich bekannten Klebebändern oder Lacken verwendet werden, da diese ohne weiteres den im nachfolgend beschriebenen Austausch-Goldbad auftretenden thermischen und/oder chemischen Belastungen gewachsen sind.

Anschließend wird der so behandelte Träger 1 in einem Austausch-Goldbad, in dem einem pH-Wert von vorzugsweise unter 7,0 und einer Temperatur von ca. 85 °C herrscht, vergoldet, wodurch in an und für sich bekannter Art und Weise eine Vorvergoldung der Kontaktflächen 2a-2c mit einer Schichtdicke von 0,03 bis 0,1 µm erzeugt wird.

Nach einem Spülen und Trocknen des Trägers 1 werden die durch das Klebeband, den Lack oder die sonstigen Abdeckmitteln ausgebildeten Abdeckungen von den Kontaktflächen 3a-3c in einer bekannten Art und Weise entfernt. Die im Austausch-Goldbad abgedeckten Kontaktflächen 3a-3c haben somit ihre ursprüngliche Chemisch-Nickel-Oberfläche behalten.

Um nun die Kontaktflächen 2a-2c für das Golddraht-Bonden auszubilden, wird der Träger 1 in ein reduktives Goldbad eingebracht, das einen Elektrolyten verwendet, bei dem auf der Grundschicht des Trägers 1, in den hier beschriebenen Fall der Chemisch-Nickel-Schicht 2, keine Goldabscheidung erfolgt. Hierbei wird bevorzugt, daß der Elektrolyt sich wie folgt zusammensetzt:
Der Elektrolyt weist als ersten Bestandteil Kalium-, Natrium- oder Ammoniumgold-I-cyanid bzw. die entsprechenden Gold-III-cyanidverbindungen in einer Größenordnung von 0,1 g/l bis ungefähr 20 g/l Gold auf, wobei bevorzugt wird, daß der Goldgehalt der vorgenannten Verbindungen im Bereich von ungefähr 0,5 g/l bis ungefähr 5 g/l liegt.

Eine zweite Komponente des beschriebenen Elektrolyten ist freies Kalium-, Natrium- oder Ammoniumcyanid in einer Größenordnung von ungefähr 0,1 g/l bis 25 g/l, wobei bevorzugt wird, daß der Anteil der vorgenannten freien Cyanide im Bereich von ungefähr 3 g/l bis 6 g/l liegt.

Desweiteren weist der Elektrolyt Kalium-, Natrium- oder Ammoniumsulfit in einer Größenordnung von ungefähr 0,1 g/l bis 50 g/l auf, wobei bevorzugt wird, daß der Gehalt des vorgenannten Sulfits im Bereich von ungefähr 5 g/l bis 15 g/l liegt.

Desweiteren weist der Elektrolyt eine aromatische (mono-, di- oder tri-) Nitroverbindung, zum Beispiel 3,5-Dinitrobenzoesäure, in der Größenordnung von ungefähr 0,01 g/l bis ungefähr 10 g/l auf, wobei wiederum bevorzugt wird, daß die Konzentration der vorgenannten Säure in den Bereich von ungefähr 0,05 bis 1,0 g/l liegt.

Ein weiterer Bestandteil des beschriebenen Elektrolyten ist freies Alkali, das vorzugsweise als Kalium- oder Natriumhydroxid vorliegt. Die Konzentration des freien Alkalis liegt in der Größenordnung von ungefähr 1 g/l bis 100 g/l, wobei der Bereich von ungefähr 10 g/l bis 25 g/l bevorzugt wird.

Ein weiterer Bestandteil des Elektrolyten sind ein oder mehrere Komplexbildner aus der Gruppe der Hydroxycarbonsäuren, Phosphonsäuren, Nitriloessigsäuren oder Aethylendiaminessigsäuren in einer Größenordnung von ungefähr 1 g/l bis 50 g/l mit einem Optimum von 10 g/l bis 30 g/l.

Desweiteren weist der beschriebene Elektrolyt einen oder mehrere Reduktionsmittel aus der Gruppe der Borane oder Boranate auf, wobei der Anteil dieser Reduktionsmittel in der Größenordnung von ungefähr 0,1 g/l bis 50 g/l mit einem Optimum von ca. 1 g/l bis 10 g/l liegt.

Um die Reaktion des Elektrolyten zu beschleunigen, kann optional noch ein Reaktionsbeschleuniger, vorzugsweise eine wasserlösliche Thallium-I-Verbindung vorgesehen sein, die in einer Größenordnung von 0,1 mg/l bis ungefähr 100 mg/l dem Elektrolyten zugesetzt wird, wobei der bevorzugte Bereich der vorgenannten Verbindung im Bereich von ungefähr 1 mg/l bis 20 mg/l liegt.

Versuche haben ergeben, daß eine bevorzugte Zusammensetzung des Elektrolyten im wesentlichen wie folgt lautet:
- 1,0 g/l Gold als freies Kaliumgold-I-cyanid,
- 5,0 g/l freies Kaliumcyanid,
- 50 g/l 1-Hydroxid-ethan-1,1-diphosphonsäure,
- 10 g/l Kaliumsulfit
- 0,2 g/l 3,5-Dinitrobenzoesäure,
- 22 g/l freies Kaliumhydroxid
- 5,0 g/l Dimethylaminboran,
wobei vorzugsweise 5,0 mg/l Thallium als Thallium-I-sulfat zugesetzt wird.

Zur Durchführung der reduktiven Goldabscheidung wird eine Temperatur von ungefähr 60° bis 95° des Elektrolyten und insbesondere der Bereich von 75° bis 85°C bevorzugt.

Der Träger 1 wird in ein diesem Goldbad bei einer Temperatur von vorzugsweise 80 °C belassen, bis sich eine Schichtdicke von ca. 0,3 µm Gold auf den Kontaktflächen 2a-2c abgeschieden hat.

Da der oben beschriebene Elektrolyt die vorteilhafte Eigenschaft aufweist, daß im reduktiven Goldbad auf der Chemisch-Nickel-Schicht 2, und somit auch auf den Kontaktschichten 3a-3c keine Goldabscheidung auftritt, werden die für das Aluminium-Bonden bestimmten Kontaktflächen 3a-3c nicht von der Goldschicht überdeckt und liegen deshalb auch nach diesem Verfahrensschritt unverändert vor.

Der Träger 1 weist somit Kontaktschichten 2a-2c auf, die eine dicke, für das Golddraht-Bonden geeignete Goldschicht aufweisen, und Kontaktflächen 3a-3c, die unvergoldet sind, auf, sodaß auf dem Träger 1 sowohl Aluminium - als auch Golddrähte gebondet werden können.

Wenn auch die verbleibenden Flächen der Grundschicht 2, also wie im hier beschriebenen Fall die Kontaktflächen 3a-3c, mit einer dünnen Goldschicht beschichtet werden sollen, so wird dies dadurch erreicht, daß der wie vorstehend behandelte Träger 1 in das weiter oben beschriebene Austausch-Goldbad eingebracht wird, bis die freien Flächen mit einer dünnen Goldschicht beschichtet sind, welche noch mit Aluminiumdraht bondbar ist. Es wird bevorzugt, daß deren Dicke ungefähr 3 zwischen 0,01 µm bis 0,09 µm liegt.

## Patentansprüche

1. Verfahren zur zumindest teilweisen Goldbeschichtung eines Trägers (1) mit einer Grundschicht (2), bei dem erste Kontaktflächen (2a-2c) auf dem Träger (1), die eine Goldschicht aufweisen, und zweite Kontaktflächen (3a-3c), die frei von der beschichteten Goldschicht der Kontaktflächen (2a-2c) sind, erzeugt werden, wobei die zweiten Kontaktflächen (3a-3c) zuerst mit einem Abdeckmittel abgedeckt werden, wobei der Träger (1) in ein Austausch-Goldbad eingebracht wird, und wodurch auf den ersten Kontaktflächen (2a-2c) eine Vorvergoldung ausgebildet wird, danach wird der Träger (1) aus dem Austausch-Goldbad entnommen und die die zweiten Kontaktflächen (3a-3c) abdekkenden Abdeckmittel werden entfernt, dadurch gekennzeichnet, daß der Träger in ein Goldbad eingebracht wird, das einen Elektrolyten aufweist, bei dem auf der Grundschicht (2) des Trägers (1) keine Goldabscheidung erfolgt, jedoch Goldabscheidung auf die vorvergoldeten Kontaktflächen (2a-2c) stattfindet.

2. Verfahren nach Anspruch 1, dadurch gekennzeichnet, daß äls Grundschicht des Trägers (1) eine Chemisch-Nickel-Schicht (2) verwendet wird, und daß das Goldbad ein reduktives Goldbad ist.

3. Verfahren nach Anspruch 2, dadurch gekennzeichnet, daß ein Elektrolyt für das reduktive Goldbad verwendet wird, der
- Kalium-, Natrium- oder Ammoniumgold-I-cyanid oder Gold-III-cyanidverbindungen in einer Größenordnung von ungefähr 0,1 g/l bis ungefähr 20 g/l,
- freies Kalium-, Natrium- oder Ammoniumcyanid in einer Größenordnung von ungefähr 0,1 g/l bis 25 g/l,
- Kalium-, Natrium- oder Ammoniumsulfit in einer Größenordnung von ungefähr 0,1 g/l bis ungefähr 50 g/l,
- einer aromatische Nitroverbindung in einer Größenordnung von ungefähr 0,1 g/l bis ungefähr 10 g/l,
- freies Alkali in einer Größenordnung von ungefähr 1 g/l bis ungefähr 100 g/l,
- einen oder mehrere Komplexbildner aus der Gruppe der Hydroxycarbonsäuren, Phosphonsäuren, Nitriloessigsäure oder Aethylendiaminessigsäuren in einer Größenordnung von ungefähr 1 g/l bis ungefähr 50 g/l,
- ein oder mehrere Reduktionsmittel aus der Gruppe der Borane oder Boranate in einer Größenordnung von 0,1 g/l bis 50 g/l
enthält.

4. Verfahren nach Anspruch 3, dadurch gekennzeichnet, daß der Elektrolyt ungefähr 0,5 g/l bis ungefähr 5 g/l Gold enthält.

5. Verfahren nach einem der vorangehenden Ansprüche, dadurch gekennzeichnet, daß der Elektrolyt ungefähr 3,0 g/l bis ungefähr 6,0 g/l an freiem Kalium-, Natrium- oder Ammoniumcyanid enthält.

6. Verfahren nach einem der vorangehenden Ansprüche, dadurch gekennzeichnet, daß der Elektrolyt Kalium-, Natrium- oder Ammoniumsulfit in der Größenordnung von ungefähr 5,0 gl bis ungefähr 15,0 g/l enthält.

7. Vefahren nach einem der vorangehenden Ansprüche, dadurch gekennzeichnet, daß der Elektrolyt die aromatische Nitroverbindung in der Größenordnung von ungefähr 0,05 g/l bis ungefähr 1 g/l enthält.

8. Verfahren nach einem der vorangehenden Ansprüche, dadurch gekennzeichnet, daß das freie Alkali als Kalium- oder Natriumhydroxid vorliegt.

9. Verfahren nach einem der vorangehenden Ansprüche, dadurch gekennzeichnet, daß das freie Alkali in der Größenordnung von ungefähr 10 g/l bis ungefähr 25 g/l vorliegt

10. Verfahren nach einem der vorangehenden Ansprüche, dadurch gekennzeichnet, daß die Reduktionsmittel in der Größenordnung von ungefähr 1 g/l bis ungefähr 10 g/l vorliegen.

11. Verfahren nach einem der vorangehenden Ansprüche, dadurch gekennzeichnet, daß dem Elektrolyt ein Reaktionsbeschleuniger zugesetzt ist.

12. Verfahren nach einem der vorangehenden Ansprüche, dadurch gekennzeichnet, daß der Reaktionsbeschleuniger eine wasserlösliche Thallium-1-Verbindung ist.

13. Verfahren nach einem der vorangehenden Ansprüche, dadurch gekennzeichnet, daß die Konzentration der wasserlöslichen Thallium-I-Verbindung in einer Größenordnung von ungefähr 0,1 mg/l bis ungefähr 100 mg/l und vorzugsweise im Bereich von ungefähr 1 mg/l bis 20 mg/l liegt.

14. Verfahren nach einem der vorangehenden Ansprüche, dadurch gekennzeichnet, daß die aromatische Nitroverbindung eine mono-, di- oder tri-Nitroverbindung ist.

15. Verfahren nach einem der vorangehenden Ansprüche, dadurch gekennzeichnet, daß die Nitroverbindung Dinitrobenzoesäure, insbesondere 3,5 Dinitrobenzoesäure, ist.

16. Verfahren nach Anspruch 1, dadurch gekennzeichnet, daß der Träger nach der Behandlung in dem reduktiven Goldbad wiederum in das Austausch-Goldbad eingebracht wird, um auf den zweiten Flächen (3a-3c) eine dünne Goldschicht aufzubringen.

## Revendications

1. Procédé pour recouvrir au moins partiellement d'une mince couche d'or un support (1) possédant une couche de base (2), dans lequel on obtient des premières surfaces de contact (2a-2c) sur le support (1) qui présentent une couche d'or et des secondes surfaces de contact (3a-3c) qui sont exemptes de la couche d'or recouvrant les surfaces de contact (2a-2c), les secondes surfaces de contact (3a-3c) étant dans un premier temps recouvertes d'un agent de recouvrement, dans lequel le support (1) est plongé dans un bain d'or par échange, et par lequel on obtient, sur les premières surfaces de contact (2a-2c), une dorure préalable, puis on retire le support (1) du bain d'or par échange et on élimine l'agent de recouvrement recouvrant les secondes surfaces de contact (3a-3c), caractérisé en ce que le support est plongé dans un bain d'or qui présente un électrolyte dans lequel aucune précipitation d'or n'a lieu sur la couche de base (2) du support (1), tandis qu'une précipitation d'or a lieu sur les surfaces de contact (2a-2c) soumises à une dorure préalable.

2. Procédé selon la revendication 1, caractérisé en ce qu'on utilise, à titre de couche de base du support (1), une couche de nickel (2) obtenue par un procédé chimique et en ce que le bain d'or est un bain d'or réducteur.

3. Procédé selon la revendication 2, caractérisé en ce qu'on utilise un électrolyte pour le bain d'or réducteur qui contient
- de composés cyanure de potassium-, de sodium-ou d'ammonium-or-I ou de cyanure d'or-III dans un ordre de grandeur d'environ 0,1 g/l à environ 20 g/l,
- du cyanure libre de potassium, de sodium ou d'ammonium dans un ordre de grandeur d'environ 0,1 g/l à 25 g/l,
- du sulfite de potassium, de sodium ou d'ammonium dans un ordre de grandeur d'environ 0,1 g/l à environ 50 g/l,
- un composé nitro aromatique dans un ordre de grandeur d'environ 0,1 g/l à environ 10 g/l,
- un alcali libre dans un ordre de grandeur d'environ 1 g/l à environ 100 g/l,
- un ou plusieurs formateurs de complexes choisis parmi le groupe comprenant des acides hydroxycarboxyliques, des acides phosphoniques, l'acide nitriloacétique ou des acides acétylènediaminoacétiques dans un ordre de grandeur d'environ 1 g/l à environ 50 g/l,
- un ou plusieurs réducteurs choisis parmi le groupe comprenant des boranes ou des boranates dans un ordre de grandeur de 0,1 g/l à 50 g/l.

4. Procédé selon la revendication 3, caractérisé en ce que l'électrolyte contient de l'or à concurrence d'environ 0,5 g/l à environ 5 g/l.

5. Procédé selon l'une quelconque des revendications précédentes, caractérisé en ce que l'électrolyte contient du cyanure de potassium, de sodium ou d'ammonium à concurrence d'environ 3,0 g/l à environ 6,0 g/l.

6. Procédé selon l'une quelconque des revendications précédentes, caractérisé en ce que l'électrolyte contient du sulfite de potassium, de sodium ou d'ammonium dans un ordre de grandeur d'environ 5,0 g/l à environ 15,0 g/l.

7. Procédé selon l'une quelconque des revendications précédentes, caractérisé en ce que l'électrolyte contient le composé nitro aromatique de l'ordre de grandeur d'environ 0,05 g/l à environ 1 g/l.

8. Procédé selon l'une quelconque des revendications précédentes, caractérisé en ce que l'alcali libre est présent sous forme d'hydroxyde de potassium ou de sodium.

9. Procédé selon l'une quelconque des revendications précédentes, caractérisé en ce que l'alcali libre est présent dans l'ordre de grandeur d'environ 10 g/l à environ 20 g/l.

10. Procédé selon l'une quelconque des revendications précédentes, caractérisé en ce que le réducteur est présent dans l'ordre de grandeur d'environ 1 g/l à environ 10 g/l.

11. Procédé selon l'une quelconque des revendications précédentes, caractérisé en ce qu'on ajoute à l'électrolyte un accélérateur de la réaction.

12. Procédé selon l'une quelconque des revendications précédentes, caractérisé en ce que l'accélérateur de la réaction est un composé hydrosoluble de thallium-I.

13. Procédé selon l'une quelconque des revendications précédentes, caractérisé en ce que la concentration du composé hydrosoluble de thallium-(I) se situe dans l'ordre de grandeur d'environ 0,1 mg/l à environ 100 mg/l, de préférence dans le domaine d'environ 1 mg/l à 20 mg/l.

14. Procédé selon l'une quelconque des revendications précédentes, caractérisé en ce que le composé nitro aromatique est un composé mono-, di- ou tri-nitro.

15. Procédé selon l'une quelconque des revendications précédentes, caractérisé en ce que le composé nitro est l'acide dinitrobenzoïque, en particulier l'acide 3,5-dinitrobenzoïque.

16. Procédé selon la revendication 1, caractérisé en ce qu'on plonge le support après le traitement dans le bain d'or réducteur à nouveau dans le bain d'or par échange pour appliquer, sur les secondes surfaces (3a-3c), une mince couche d'or.

## Claims

1. Method for at least partially coating a carrier (1) with gold, the carrier (1) having a base layer (2), in which first contact surfaces (2a-2c) on the carrier (1), which comprise a gold layer, and second contact surfaces (3a-3c), which are free of the coated gold layer of the contact surfaces (2a-2c), are formed, with the second contact surfaces (3a-3c) being firstly covered with a cover means, with the carrier (1) being brought into an exchange gold bath and wherein the first contact surfaces (2a-2c) are pre-plated with gold, afterwards the carrier (1) is taken out of the exchange gold bath and the cover means, which cover the second contact surfaces (3a-3c) are removed, characterized in that the carrier is brought into a gold bath, which comprises an electrolyte, in which on the base layer (2) of the carrier (1) no deposition of gold is achieved, however deposition of gold occurs on the contact surfaces (2a-2c) which are pre-plated with gold.

2. The method according to claim 1, characterized in that as a base layer of the carrier (1) a chemically deposited nickel layer (2) is used, and that the gold bath is a reducing gold bath.

3. The method according to claim 2, characterized in that for the reducing gold bath an electrolyte is used, which comprises
- potassium gold-I-cyanide, sodium gold-I-cyanide or ammonium gold-I-cyanide or gold-III-cyanide compounds in an order of magnitude between approximately 0.1 g/l and approximately 20 g/l,
- uncombined potassium cyanide, sodium cyanide or ammonium cyanide in an order of magnitude between approximately 0.1 g/l and 25 g/l,
- potassium sulphite, sodium sulphite or ammonium sulphite in an order of magnitude between approximately 0.1 g/l and approximately 50 g/l,
- an aromatic nitro compound in an order of magnitude between approximately 0.1 g/l and approximately 10 g/l,
- uncombined alkali in an order of magnitude between approximately 1 g/l and approximately 100 g/l,
- one or several complexing agents selected from the group of the hydroxycarboxylic acids, phosphonic acids, nitrilo-acetic acids or ethylene diamine acetic acids in an order of magnitude between approximately 1 g/l and approximately 50 g/l,
- one or several reducing agents selected from the group of the boranes or boranates in an order of magnitude between 0.1 g/l and 50 g/l.

4. The method according to claim 3, characterized in that the electrolyte comprises between approximately 0.5 g/l and approximately 5 g/l gold.

5. The method according to any of the afore-mentioned claims, characterized in that the electrolyte comprises between approximately 3.0 g/l and approximately 6.0 g/l of uncombined potassium cyanide, sodium cyanide or ammonium cyanide.

6. The method according to any of the afore-mentioned claims, characterized in that the electrolyte comprises potassium sulphite, sodium sulphite or ammonium sulphite in the order of magnitude between approximately 5.0 g/l and approximately 15.0 g/l.

7. The method according to any of the afore-mentioned claims, characterized in that the electrolyte comprises the aromatic nitro compound in the order of magnitude between approximately 0.05 g/l and approximately 1 g/l.

8. The method according to any of the afore-mentioned claims, characterized in that the uncombined alkali is present as potassium hydroxide or sodium hydroxide.

9. The method according to any of the afore-mentioned claims, characterized in that the uncombined alkali is present in the order of magnitude between approximately 10 g/l and approximately 25 g/l.

10. The method according to any of the afore-mentioned claims, characterized in that the reducing agents are present in the order of magnitude between approximately 1 g/l and approximately 10 g/l.

11. The method according to any of the afore-mentioned claims, characterized in that a reaction catalyst is added to the electrolyte.

12. The method according to any of the afore-mentioned claims, characterized in that the reaction catalyst is a water-soluble thallium-I-compound.

13. The method according to any of the afore-mentioned claims, characterized in that the concentration of the water-soluble thallium-I-compound has an order of magnitude between approximately 0.1 mg/l and approximately 100 mg/l and is preferably in the range between approximately 1 mg/l and 20 mg/l.

14. The method according to any of the afore-mentioned claims, characterized in that the aromatic nitro compound is a mono-, di- or trinitro compound.

15. The method according to any of the afore-mentioned claims, characterized in that the nitro compound is a dinitrobenzoic acid, especially 3,5 dinitrobenzoic acid.

16. The method according to claim 1, characterized in that after the treatment in the reducing gold bath the carrier is brought into the exchange gold bath again, in order to deposit a thin gold layer onto the second surfaces (3a-3c).
